# EUROPEAN PATENT SPECIFICATION

(11) **EP 1 868 211 B1**
(45) Date of publication and mention of the grant of the patent: **10.01.2018**
(21) Application number: 06715431.0
(22) Date of filing: 09.03.2006
(51) Int. Cl.: H01B 13/00, H01L 39/24

(54) **PROCESS FOR PRODUCING BISMUTH-BASED OXIDE SUPERCONDUCTOR, AND SUPERCONDUCTIVE WIRE**
VERFAHREN ZUR HERSTELLUNG EINES BISMUT-BASIERTEN OXID-SUPRALEITERS UND SUPRALEITENDER DRAHT
PROCÉDÉ POUR PRODUIRE UN SUPERCONDUCTEUR À BASE D'OXYDE DE BISMUTH ET FIL SUPRACONDUCTEUR

(30) Priority: 06.04.2005 JP 2005110157
(43) Date of publication of application: 19.12.2007
(73) Proprietor: Sumitomo Electric Industries, Ltd., Osaka-shi, Osaka 541-0041 (JP)
(72) Inventor: AYAI, Naoki, Osaka-shi, Osaka 554-8511 (JP)
(74) Representative: Kreutzer, Ulrich
(86) International application number: PCT/JP2006/304560
(87) International publication number: WO 2006/112195

(56) References cited:
- WO-A1-99/13517
- JP-A- 04 237 910
- JP-A- 09 115 356
- JP-A- 2000 200 520
- SAILER B ET AL: "Effect of precursor powder properties on magnetic and electrical transport properties of (Bi,Pb)-2223-tapes" IEEE TRANSACTIONS ON APPLIED SUPERCONDUCTIVITY, vol. 11, no. 1, March 2001 (2001-03), pages 2975-2978, XP011090958 ISSN: 1051-8223
- JIANG C ET AL: "Kinetics of phase formation and transport properties of Bi-2223/Ag tapes fabricated by various calcined powders" IEEE TRANSACTIONS ON APPLIED SUPERCONDUCTIVITY, vol. 13, no. 2, June 2003 (2003-06), pages 2937-2940, XP011098149 ISSN: 1051-8223

## Description

### Technical Field

The present invention relates to a method of manufacturing a bismuth-based oxide superconductor and a superconducting wire, and more particularly, it relates to a method of manufacturing a bismuth-based oxide superconductor capable of obtaining a high critical current density and a superconducting wire containing a bismuth-based oxide superconductor manufactured by this method.

### Background Art

Oxide superconductors have recently been watched as superconductors exhibiting high critical temperatures. Among the oxide superconductors, bismuth-based oxide superconductors exhibiting high critical temperatures are expected for practical use in particular.

110 K (Kelvins), 80 K and 10 K are known as the critical temperatures of the bismuth-based oxide superconductors.

A bismuth-based oxide superconductor exhibiting the critical temperature of 110 K has a 2223 composition (such a composition that the number of Bi atoms, the number of Sr atoms, the number of Ca atoms and the number of Cu atoms are substantially in the ratios 2:2:2:3 or the sum of the numbers of Bi atoms and Pb atoms, the number of Sr atoms, the number of Ca atoms and the number of Cu atoms are substantially in the ratios 2:2:2:3) in a composition Bi-Sr-Ca-Cu or a composition (Bi,Pb)-Sr-Ca-Cu partially replacing Bi with Pb (this bismuth-based oxide superconductor may hereinafter be also referred to as "2223 phase").

A bismuth-based oxide superconductor exhibiting the critical temperature of 80 K has a 2212 composition (such a composition that the number of Bi atoms, the number of Sr atoms, the number of Ca atoms and the number of Cu atoms are substantially in the ratios 2:2:1:2 or the sum of the numbers of Bi atoms and Pb atoms, the number of Sr atoms, the number of Ca atoms and the number of Cu atoms are substantially in the ratios 2:2:1:2) in a composition Bi-Sr-Ca-Cu or a composition (Bi,Pb)-Sr-Ca-Cu partially replacing Bi with Pb (this bismuth-based oxide superconductor may hereinafter be also referred to as "2212 phase").

A bismuth-based oxide superconductor may be manufactured by a method charging a metal sheath with a raw material and performing plastic working and heat treatment on this metal sheath, for example. This method is preferably utilized in order to manufacture a long superconducting wire, for example. It is also known that the critical current density of the bismuth-based oxide superconductor can be increased according to this method by performing precise plastic working and repeating the plastic working and the heat treatment a plurality of times.

For examples, Patent Document 1 discloses a method of manufacturing a bismuth-based oxide superconductor excellent both in critical current density and in critical current, capable of promoting formation of a bismuth-based oxide superconductor exhibiting a critical temperature of 110 K and having a 2223 composition.

The method disclosed in Patent Document 1 includes the steps of preparing a raw material powder by mixing a bismuth-based oxide superconductor having a main body of a 2212 phase with a partially formed 2223 phase and a non-superconductor with each other, pulverizing this raw material and thereafter charging the same into a metal sheath, and performing plastic working and heat treatment in the metal sheath. Patent Document 1: Japanese Patent Laying-Open No. 04-212215 and corresponding EP 449161 A2

Sailer et al (IEEE TRANSACTIONS ON APPLIED SUPERCONDUCTIVITY, vol. 11, no. 1, March 2001, pages 2975-2978), teach a 2223 phase tape produced via a similar powder-in-tube technique using tetragonal 2212 phase powder which has been prepared in 0.21 atm p(O2) at 807 DEG C for 13 h, thereby exhibiting a critical temperature of 64 K (powder C).

### Disclosure of the Invention

### Problems to be Solved by the Invention

In the method disclosed in Patent Document 1, however, the 2223 phase may so randomly grow that the orientation of crystals of the 2223 phase is disordered in the step of performing heat treatment. When the orientation of the crystals of the 2223 phase is disordered, the crystal structure is so undersized that it is difficult to attain a high critical current density.

Accordingly, an object of the present invention is to provide a method of manufacturing a bismuth-based oxide superconductor capable of obtaining a high critical current density and a superconducting wire containing a bismuth-based oxide superconductor manufactured by this method.

### Means for Solving the Problems

The present invention is directed to a method of manufacturing a bismuth-based oxide superconductor containing a 2223 phase having a 2223 composition in a composition Bi-Sr-Ca-Cu or (Bi,Pb)-Sr-Ca-Cu, comprising a first step of charging a raw material containing a 2212 phase having a 2212 composition in the composition Bi-Sr-Ca-Cu or (Bi,Pb)-Sr-Ca-Cu with a critical temperature of not more than 70 K into a metal sheath, a second step of performing plastic working on the metal sheath charged with the raw material and a third step of performing heat treatment on the metal sheath charged with the raw material, wherein the average particle diameter of a non-superconductor contained in said raw material is not more than 5 µm. In the method of manufacturing a bismuth-based oxide superconductor according to the present invention, the content of the 2223 phase having the 2223 composition in the composition Bi-Sr-Ca-Cu or (Bi,Pb)-Sr-Ca-Cu in the raw material is preferably not more than 5 mass % of the raw material.

In the method of manufacturing a bismuth-based oxide superconductor according to the present invention, the 2223 phase having the 2223 composition in the composition Bi-Sr-Ca-Cu or (Bi,Pb)-Sr-Ca-Cu can be successively formed from the outer side toward the inner side of the raw material charged into the metal sheath in the third step.

In the method of manufacturing a bismuth-based oxide superconductor according to the present invention, the average particle diameter of a non-superconductor contained in the raw material is preferably not more than 2 µm.

The present invention is also directed to a superconducting wire containing a bismuth-based oxide superconductor manufactured by the aforementioned method of manufacturing a bismuth-based oxide superconductor.

In the superconducting wire according to the present invention, an orientation disorder angle of the 2223 phase of the bismuth-based oxide superconductor is preferably not more than 8.5°.

### Effects of the Invention

According to the present invention, a method of manufacturing a bismuth-based oxide superconductor capable of obtaining a high critical current density and a superconducting wire containing a bismuth-based oxide superconductor manufactured by this method can be provided.

### Brief Description of the Drawings

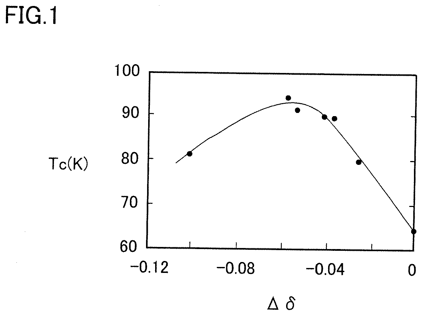

Fig. 1 is a diagram showing the relation between stoichiometry of an oxygen content in a raw material and a critical temperature.

### Best Modes for Carrying Out the Invention

The method of manufacturing a bismuth-based oxide superconductor according to the present invention is a method of manufacturing a bismuth-based oxide superconductor containing a 2223 phase having a 2223 composition in a composition Bi-Sr-Ca-Cu or (Bi,Pb)-Sr-Ca-Cu, comprising a first step of charging a raw material containing a 2212 phase having a 2212 composition in a composition Bi-Sr-Ca-Cu or (Bi,Pb)-Sr-Ca-Cu with a critical temperature of not more than 70 K into a metal sheath, a second step of performing plastic working on the metal sheath charged with the raw material and a third step of performing heat treatment on the metal sheath charged with the raw material.

According to the present invention, the 2223 phase having the 2223 composition in the composition Bi-Sr-Ca-Cu denotes an oxide superconductor containing Bi (bismuth), Sr (strontium), Ca (calcium) and Cu (copper) as metallic elements so that the number of Bi atoms, the number of Sr atoms, the number of Ca atoms and the number of Cu atoms are substantially in the atomic ratios 2:2:2:3. BiₐSr_{b}Ca_{c}Cu_{d}Oₑ (where 1.8 ≤ a ≤ 2.2, 1.8 ≤ b ≤ 2.2, 1.8 ≤ c ≤ 2.2, 2.8 ≤ d ≤ 3.2, 9 ≤ e ≤ 11) can be listed as the composition formula of the 2223 phase having the 2223 composition in the composition Bi-Sr-Ca-Cu. In this formula, a represents the ratio of the number of Bi atoms, b represents the ratio of the number of Sr atoms, c represents the ratio of the number of Ca atoms, d represents the ratio of the number of Cu atoms, and e represents the number of O (oxygen) atoms.

According to the present invention, the 2223 phase having the 2223 composition in the composition (Bi,Pb)-Sr-Ca-Cu denotes an oxide superconductor containing Bi, Pb (lead), Sr, Ca and Cu as metallic elements so that the sum of the numbers of Bi atoms and Pb atoms, the number of Sr atoms, the number of Ca atoms and the number of Cu atoms are substantially in the atomic ratios 2:2:2:3. (Bi,Pb)ₐSr_{b}Ca_{c}Cu_{d}Oₑ (where 1.8 ≤ a ≤ 2.2, 1.8 ≤ b ≤ 2.2, 1.8 ≤ c ≤ 2.2, 2.8 ≤ d ≤ 3.2, 9 ≤ e ≤ 11) can be listed as the composition formula of the 2223 phase having the 2223 composition in the composition (Bi,Pb)-Sr-Ca-Cu. In this formula, a represents the ratio of the sum of the numbers of Bi atoms and Pb atoms, b represents the ratio of the number of Sr atoms, c represents the ratio of the number of Ca atoms, d represents the ratio of the number of Cu atoms and e represents the number of O (oxygen) atoms.

According to the present invention, the 2212 phase having the 2212 composition in the composition Bi-Sr-Ca-Cu denotes an oxide superconductor containing Bi, Sr, Ca and Cu as metallic elements so that the number of Bi atoms, the number of Sr atoms, the number of Ca atoms and the number of Cu atoms are substantially in the atomic ratios 2:2:1:2. Bi_{f}Sr_{g}CaₕCuᵢOⱼ (where 1.8 ≤ f ≤ 2.2, 1.8 ≤ g ≤ 2.2, 0.8 ≤ h ≤ 1.2, 1.8 ≤ i ≤ 2.2, 7 ≤ j ≤ 9) can be listed as the composition formula of the 2212 phase having the 2212 composition in the composition Bi-Sr-Ca-Cu. In this formula, f represents the ratio of the number of Bi atoms, g represents the ratio of the number of Sr atoms, h represents the ratio of the number of Ca atoms, i represents the ratio of the number of Cu atoms and j represents the number of O atoms.

According to the present invention, the 2212 phase having the 2212 composition in the composition (Bi,Pb)-Sr-Ca-Cu denotes an oxide superconductor containing Bi, Pb, Sr, Ca and Cu as metallic elements so that the sum of the numbers of Bi atoms and Pb atoms, the number of Sr atoms, the number of Ca atoms and the number of Cu atoms are substantially in the atomic ratios 2:2:1:2. (Bi,Pb)_{f}Sr_{g}CaₕCuᵢOⱼ (where 1.8 ≤ f ≤ 2.2, 1.8 ≤ g ≤ 2.2, ≤ h ≤ 1.2, 1.8 ≤ i ≤ 2.2, 7 ≤ j ≤ 9) can be listed as the composition formula of the 2212 phase having the 2212 composition in the composition (Bi,Pb)-Sr-Ca-Cu. In this formula, f represents the ratio of the sum of the numbers of Bi atoms and Pb atoms, g represents the ratio of the number of Sr atoms, h represents the ratio of the number of Ca atoms, i represents the ratio of the number of Cu atoms and j represents the number of O atoms.

According to the present invention, the raw material containing the 2212 phase having the 2212 composition in the composition Bi-Sr-Ca-Cu or (Bi,Pb)-Sr-Ca-Cu with the critical temperature (maximum temperature developing a superconducting phenomenon) of not more than 70 K is charged into the metal sheath, the metal sheath is subjected to plastic working, and the metal sheath is thereafter heat-treated. According to the present invention, oxygen contained in the raw material is discharged through the metal sheath in the aforementioned heat treatment. Thus, the raw material has a high oxygen concentration hardly forming a 2223 phase on the inner side thereof and a low oxygen concentration easily forming a 2223 phase on the outer side thereof, for forming such a gradient of the oxygen concentration that the oxygen concentration is increased from the outer side toward the inner side of the raw material.

According to the present invention, therefore, crystals of the 2223 phase are first formed on the outer side of the raw material to be oriented along the interface between the raw material and the metal sheath, due to the aforementioned gradient of the oxygen concentration. Thereafter crystals of the 2223 phase on the inner side of the raw material are restrained by the precedently formed large crystals of the 2223 phase on the outer side and successively formed to be oriented along these crystals. Thus, a bismuth-based oxide superconductor manufactured according to the present invention has such a structure that crystals of the 2223 phase are unidirectionally oriented as a whole, so that a high critical current density can be obtained.

Thus, the 2223 phase capable of obtaining a high critical current density can be obtained by forming the gradient of the oxygen concentration in the raw material charged into the metal sheath conceivably because the raw material contains a larger quantity of oxygen as compared with a conventional raw material for forming a 2223 phase. However, it is difficult to determine the oxygen content in the raw material, and hence the critical temperature of the 2212 phase having a constant correlation with the oxygen content in the raw material is set to not more than 70 K. The correlation between the oxygen content in the raw material and the critical temperature is described in Physica C 176 (1991), pp. 95 to 105, Fig. 6(b), for example. Fig. 1 shows the correlation between the oxygen content in the raw material and the critical temperature described in this literature. Referring to Fig. 1, the axis of ordinates shows the stoichiometry Δδ of oxygen, and the axis of ordinates shows the critical temperature Tc (K).

The raw material employed for the method of manufacturing a bismuth-based oxide superconductor according to the present invention contains the 2212 phase having the 2212 composition in the composition Bi-Sr-Ca-Cu or (Bi,Pb)-Sr-Ca-Cu with the critical temperature of not more than 70 K. This is for increasing the oxygen concentration in the raw material.

According to the present invention, the content of the 2223 phase having the 2223 composition in the composition Bi-Sr-Ca-Cu or (Bi,Pb)-Sr-Ca-Cu in the raw material is preferably not more than 5 mass % of the raw material, more preferably not more than 1 mass %. If the 2223 phase is present in the raw material in a large quantity, the 2223 phase partially present in the raw material functions as a nucleus for forming the 2223 phase in the metal sheath. When the raw material is finely pulverized for refining the 2212 phase, the 2223 phase and a non-superconducting phase together upon formation of the nucleus and plastic working and heat treatment are performed in this state, there is such a tendency that the 2223 phase dispersed in the metal sheath forms starting points of growth, crystals grow from the starting points of the dispersed 2223 phase respectively and the orientation of the crystals of the 2223 phase is deteriorated. Consequently, there is such a tendency that it is difficult to obtain a high critical current density. In order to obtain a high critical current density by ordering the orientation of the crystals of the 2223 phase, the content of the 2223 phase in the raw material is preferably not more than 5 mass % of the raw material, more preferably not more than 1 mass %.

The raw material may further contain Bi₂Sr₂CuOₓ (2201 phase), (Bi,Pb)₂Sr₂Ca₂Cu₃Oₓ (2223 phase), (Ca,Sr)₂PbO₄(CP), (Pb,Bi)₃Sr₂Ca₂CuOₓ (3221 phase), (CaSr)₁₄Cu₂₄O₃(14-24AEC), (CaSr)₁₋ᵣCuO₂(1-1AEC) (CaSr)₂CuO₃(2-1AEC) or CuO, in addition to the 2212 phase.

The raw material employed in the present invention can be obtained by repeating burning and pulverization a plurality of times on a mixture obtained by mixing nitrates or oxides and a carbooxide of Bi, Pb, Sr, Ca and Cu to be in prescribed ratios, for example.

A wet ball mill, a dry ball mill or an attriter is employed for the pulverization, for example. Further, exemplary burning conditions are an atmosphere having an oxygen partial pressure of at least 2.03 kPa and not more than 101.3 kPa and a burning temperature of at least 750°C and not more than 850°C.

The structure of the raw material employed in the present invention can be varied with manufacturing conditions in preparation of the raw material. For example, there is such a tendency that the quantities of tetragonal systems of a 2212 phase expressed in a composition formula Bi₂Sr₂CaCu₂Oₓ, CP, a 3221 phase and 14-24 AEC are increased when the aforementioned burning is performed in an atmosphere having a high oxygen concentration of about 20 to 100 %, while there is such a tendency that the quantities of orthorhombic systems of a 2212 phase expressed in a composition formula (Bi,Pb)₂Sr₂CaCu₂Oₓ, 1-1AEC and CuO are increased when the aforementioned burning is performed in an atmosphere having a low oxygen concentration of about 0 to 20 %. The aforementioned oxygen concentration expresses the ratio of the volume of oxygen to the volume of overall gas constituting the atmosphere.

In order to increase the critical current density of the bismuth-based oxide superconductor manufactured according to the present invention, the average particle diameter of a material, other than the 2212 phase, contained in the raw material charged into the metal sheath is not more than 5 µm, preferably not more than 2 µm. In order to increase the critical current density of the bismuth-based oxide superconductor manufactured according to the present invention, the maximum particle diameter of the material, other than the 2212 phase, contained in the raw material charged into the metal sheath is preferably not more than 10 µm.

In particular, the average particle diameter of the non-superconductor contained in the raw material charged into the metal sheath is preferably set to not more than 5 µm, so that the non-superconductor can be more finely dispersed into the bismuth-based oxide superconductor according to the present invention. This is because there is such a possibility that formation of the 2223 phase is retarded in the third step of performing heat treatment on the metal sheath charged with the raw material, the non-superconductor is aggregated to reduce the quantity of formation of the 2223 phase and the critical current density of the bismuth-based oxide superconductor manufactured according to the present invention is reduced if the average particle diameter of the non-superconductor contained in the raw material is in excess of 5 µm. In order to more increase the critical current density of the bismuth-based oxide superconductor manufactured according to the present invention, the average particle diameter of the non-superconductor contained in the raw material charged into the metal sheath is preferably not more than 2 µm. In order to increase the critical current density of the bismuth-based oxide superconductor manufactured according to the present invention, the maximum particle diameter of the non-superconductor contained in the raw material charged into the metal sheath is preferably not more than 10 µm.

The raw material is charged into the metal sheath, so that the second step of performing plastic working on the metal sheath charged with the raw material and the third step of performing heat treatment on the metal sheath charged with the raw material are thereafter carried out. The second and third steps can be alternately carried out a plurality of times. For example, wiredrawing or rolling can be listed as the plastic working.

According to the present invention, the material for the metal sheath is preferably constituted of a metal or an alloy, not reacting with the bismuth-oxide superconductor, having low resistance. Further, the material for the metal sheath preferably allows permeation of oxygen contained in the raw material. For example, silver, a silver alloy, gold or a gold alloy can be listed as the material for the metal sheath. Alternatively, a metal sheath having a surface, coming into contact with the raw material, coated with a layer of the aforementioned material (silver, a silver alloy, gold or a gold alloy, for example) may be employed. The metal sheath preferably functions as a stabilizer under working conditions of the bismuth-based oxide superconductor according to the present invention.

While a superconducting wire employing the bismuth-based oxide superconductor manufactured in the aforementioned manner is obtained according to the present invention, the orientation disorder angle of the 2223 phase of the bismuth-based oxide superconductor is preferably not more than 8.5°. In this case, the critical current density of the superconductor tends to increase. According to the present invention, the orientation disorder angle is defined as 1/2 of the half width of a rocking curve of the (0024) plane of the 2223 phase constituting the superconducting wire according to the present invention measured by an X-ray diffraction method. Examples

### (Examples 1 to 4 and Comparative Examples 1 and 2)

Each of superconducting wires according to Examples 1 to 4 and comparative examples 1 and 2 was prepared as follows: First, a solution obtained by mixing Bi₂O₃, PbO, SrCO₃, CaCO₃ and CuO with each other so that the number of Bi atoms, the number of Pb atoms, the number of Sr atoms, the number of Ca atoms and the number of Cu atoms were in the ratios 1.7:0.4:2.0:2.0:3.0 and dissolving the mixture into nitric acid was spray-dried at a high temperature, for preparing powder.

This powder was burned at a temperature of 700°C to 860°C, and pulverized after burning. This burning and pulverization were repeated, for preparing a raw material containing a 2212 phase expressed in a composition formula (Bi,Pb)₂Sr₂CaCu₂O_{8+δ}, Ca-Sr-Cu-O, Ca₂₋ₓSrₓPbO₄(CP) and (Pb,Bi)₃(Sr,Ca,Bi)₅CuO_{12+δ} (3321 phase) (δ denotes a fraction). The raw material hardly contained a 2223 phase having a 2223 phase in a composition Bi-Sr-Ca-Cu or (Bi,Pb)-Sr-Ca-Cu, and the content of the 2223 phase was not more than 5 mass % of the raw material. The conditions for the aforementioned pulverization were so adjusted that the average particle diameters of subphases consisting of the materials other than the 2212 phase in the raw material were not more than 2 µm, not more than 5 µm and not more than 10 µm respectively, for preparing three types of raw materials containing subphases having different average particle diameters.

The raw materials obtained in the aforementioned manner were heated in atmospheres of heating temperatures and oxygen partial pressures shown in Table 1 for five hours in the range of 700°C to 830°C respectively for adjusting the concentrations of oxygen contained in the raw materials, and the critical temperatures of the 2212 phases were measured by a magnetization method. Table 1 shows the critical temperatures of the 2212 phases of the raw materials employed for preparing the superconducting wires according to Examples 1 to 4 and comparative examples 1 and 2 respectively.

Then, the aforementioned raw materials were charged into metal sheaths of silver respectively, for preparing single-filamentary wires by wiredrawing the metal sheaths charged with the raw materials respectively. The single-filamentary wires were cut for bundling 55 single-filamentary wires, and the bundled single-filamentary wires were inserted into a metal sheath of silver. Thereafter a multifilamentary wire was prepared by further wiredrawing the metal sheath.

The multifilamentary wire prepared in the aforementioned manner was rolled into a tapelike multifilamentary wire having a width of 4 mm and a thickness of 0.2 mm. Then, the tapelike multifilamentary wire was heat-treated in an atmosphere having a temperature of 820°C to 850°C and an oxygen partial pressure of 8106 Pa for 30 hours, thereby forming a 2223 phase.

After the aforementioned heat treatment, the multifilamentary wire was rolled and further heat-treated in an atmosphere having a temperature of 800°C to 825°C and an oxygen partial pressure of 8106 Pa for 50 hours. Thus, superconducting wires according to Examples 1 to 4 and comparative examples 1 and 2 containing 2223 phases expressed in a composition formula (Bi,Pb)₂Sr_{1.9}Ca₂Cu₃O_{10+δ} were prepared.

The orientation disorder angles were measured as to the respective 2223 phases constituting the superconducting wires according to Examples 1 to 4 and comparative examples 1 and 2. Further, the critical current densities of the superconducting wires according to Examples 1 to 4 and comparative examples 1 and 2 were measured respectively. Table 1 shows these results.

A 2223 phase was exposed by removing the metal sheath of silver, and then a rocking curve of the (0024) plane of the exposed 2223 phase was measured. 1/2 of the half width of the rocking curve was defined as the orientation disorder angle of each superconducting wire. The critical current density was calculated by measuring a current-field curve in liquid nitrogen of 77 K by a four-probe method, defining the critical current value with reference to a field of 1 µV/cm and dividing the critical current value by the sectional area (area of a section in a direction perpendicular to that of flow of a critical current) of the superconducting wire.

**Table 1**

| | Conditions for Adjusting Oxygen Concentration | | Raw Material | | Evaluation of Superconducting Wire | |
|---|---|---|---|---|---|---|
| | Heating Temperature (°C) | Oxygen Partial Pressure (atm) | Average Particle Diameter of Subphase (µm) | Critical Temperature of 2212 Phase (K) | Orientation Disorder Angle (°) | Critical Current Density (kA/cm²) |
| Comparative Example 1 | 700 | 0 | ≤ 2 | 78 | 11.2 | 23 |
| Comparative Example 2 | 740 | 0.08 | ≤ 2 | 72 | 10.6 | 22 |
| Example 1 | 780 | 0.2 | ≤ 2 | 70 | 8.3 | 30 |
| Example 2 | 830 | 1 | ≤ 2 | 66 | 7.4 | 33 |
| Example 3 | 830 | 1 | ≤ 5 | 66 | 7.5 | 25 |
| Example 4 | 830 | 1 | ≤ 10 | 66 | 7.3 | 13 |

As shown in Table 1, there has been such a tendency that the critical current densities of the superconducting wires having average particle diameters of subphases of not more than 5 µm in the raw materials with orientation disorder angles of not more than 8.5° were increased. In particular, the critical current densities of the superconducting wires having average particle diameters of subphases of not more than 2 µm in the raw materials with orientation disorder angles of not more than 8.5° were further increased.

The embodiment and Examples disclosed this time are to be considered illustrative in all points and not restrictive. The range of the present invention is shown not by the above description but by the scope of claim for patent, and it is intended that all modifications within the meaning and range equivalent to the scope of claim for patent are included.

### Industrial Availability

According to the present invention, a method of manufacturing a bismuth-based oxide superconductor capable of obtaining a high critical current density and a superconducting wire containing a bismuth-based oxide superconductor manufactured by this method can be provided.

## Claims

1. A method of manufacturing a bismuth-based oxide superconductor containing a 2223 phase having a 2223 composition in a composition Bi-Sr-Ca-Cu or (Bi,Pb)-Sr-Ca-Cu,
comprising a first step of charging a raw material containing a 2212 phase having a 2212 composition in the composition Bi-Sr-Ca-Cu or (Bi,Pb)-Sr-Ca-Cu with a critical temperature of not more than 70 K into a metal sheath, a second step of performing plastic working on said metal sheath charged with said raw material and a third step of performing heat treatment on said metal sheath charged with said raw material,
**characterised in that** the average particle diameter of a non-superconductor contained in said raw material is not more than 5 µm.

2. The method of manufacturing a bismuth-based oxide superconductor according to claim 1, wherein
the content of the 2223 phase having the 2223 composition in the composition Bi-Sr-Ca-Cu or (Bi,Pb)-Sr-Ca-Cu in said raw material is not more than 5 mass % of said raw material.

3. The method of manufacturing a bismuth-based oxide superconductor according to claim 1, wherein
the 2223 phase having the 2223 composition in the composition Bi-Sr-Ca-Cu or (Bi,Pb)-Sr-Ca-Cu is successively formed from the outer side toward the inner side of said raw material charged into said metal sheath in said third step.

4. The method of manufacturing a bismuth-based oxide superconductor according to any of the preceding claims, wherein
the average particle diameter of the non-superconductor contained in said raw material is not more than 2 µm.

5. A superconducting wire containing a bismuth-based oxide superconductor manufactured by the method of manufacturing a bismuth-based oxide superconductor according to claim 1.

6. A superconducting wire containing a bismuth-based oxide superconductor according to claim 5 and manufactured by the method of manufacturing a bismuth-based oxide superconductor according to claim 4.

7. The superconducting wire according to claim 5 or 6,
wherein an orientation disorder angle of the 2223 phase of said bismuth-based oxide superconductor is not more than 8.5°,
wherein the orientation disorder angle of the 2223 phase of the bismuth-based oxide superconductor is defined as ½ of the half width of a rocking curve of the (0024) plane of the 2223 phase constituting the superconducting wire measured by an X-ray diffraction method.

## Patentansprüche

1. Verfahren zum Herstellen eines Bismut-basierten Oxid-Supraleiters, der eine 2223-Phase enthält, die eine 2223-Zusammensetzung in einer Zusammensetzung Bi-Sr-Ca-Cu oder (Bi,Pb)-Sr-Ca-Cu aufweist,
das umfasst: einen ersten Schritt des Beschickens eines Rohstoffs, der eine 2212-Phase enthält, die eine 2212-Zusammensetzung in der Zusammensetzung Bi-Sr-Ca-Cu oder (Bi,Pb)-Sr-Ca-Cu mit einer kritischen Temperatur von nicht mehr als 70 K aufweist, in einen Metallmantel, einen zweiten Schritt des Ausführens einer plastischen Bearbeitung des mit dem Rohstoff beschickten Metallmantels, und einen dritten Schritt des Ausführens einer Wärmebehandlung des mit dem Rohstoff beschickten Metallmantels,
**dadurch gekennzeichnet, dass** der durchschnittliche Partikeldurchmesser eines in dem Rohstoff enthaltenen Nicht-Supraleiters maximal 5 µm beträgt.

2. Verfahren zum Herstellen eines Bismut-basierten Oxid-Supraleiters nach Anspruch 1, wobei der Gehalt der 2223-Phase, die die 2223-Zusammensetzung in der Zusammensetzung Bi-Sr-Ca-Cu oder (Bi,Pb)-Sr-Ca-Cu aufweist, in dem Rohstoff nicht mehr als 5 Masse-% des Rohstoffs beträgt.

3. Verfahren zum Herstellen eines Bismut-basierten Oxid-Supraleiters nach Anspruch 1, wobei die 2223-Phase, die die 2223-Zusammensetzung in der Zusammensetzung Bi-Sr-Ca-Cu oder (Bi,Pb)-Sr-Ca-Cu aufweist, nacheinander von der Außenseite her in Richtung der Innenseite des Rohstoffs, der in dem dritten Schritt in den Metallmantel beschickt wurde, gebildet wird.

4. Verfahren zum Herstellen eines Bismut-basierten Oxid-Supraleiters nach einem der vorangehenden Ansprüche, wobei der durchschnittliche Partikeldurchmesser des in dem Rohstoff enthaltenen Nicht-Supraleiters nicht mehr als 2 µm beträgt.

5. Supraleitender Draht, der einen Bismut-basierten Oxid-Supraleiter enthält, der durch das Verfahren zum Herstellen eines Bismut-basierten Oxid-Supraleiters nach Anspruch 1 hergestellt ist.

6. Supraleitender Draht, der einen Bismut-basierten Oxid-Supraleiter nach Anspruch 5 enthält und durch das Verfahren zum Herstellen eines Bismut-basierten Oxid-Supraleiters nach Anspruch 4 hergestellt ist.

7. Supraleitender Draht nach Anspruch 5 oder 6,
wobei ein Orientierungsstörungswinkel der 2223-Phase des Bismut-basierten Oxid-Supraleiters maximal 8,5° beträgt, und
wobei der Orientierungsstörungswinkel der 2223-Phase des Bismut-basierten Oxid-Supraleiters als die Hälfte der halben Breite einer Rocking-Kurve der (0024)-Ebene der 2223-Phase, die den supraleitenden Draht bildet, durch ein Röntgendiffraktionsverfahren gemessen, definiert ist.

## Revendications

1. Procédé de fabrication d'un supraconducteur de type oxyde à base de bismuth contenant une phase 2223 ayant une composition 2223 dans une composition de Bi-Sr-Ca-Cu ou (Bi,Pb)-Sr-Ca-Cu,
comprenant une première étape consistant à charger une matière première contenant une phase 2212 ayant une composition 2212 dans la composition de Bi-Sr-Ca-Cu ou (Bi,Pb)-Sr-Ca-Cu avec une température critique ne dépassant pas 70 K dans une gaine métallique, une deuxième étape consistant à réaliser un usinage plastique sur ladite gaine métallique chargée de ladite matière première, et une troisième étape consistant à réaliser un traitement à la chaleur sur ladite gaine métallique chargée de ladite matière première,
**caractérisé en ce que** la granulométrie moyenne d'un non-supraconducteur contenu dans ladite matière première ne dépasse pas 5 µm.

2. Procédé de fabrication d'un supraconducteur de type oxyde à base de bismuth selon la revendication 1, dans lequel la teneur en la phase 2223 ayant la composition 2223 dans la composition de Bi-Sr-Ca-Cu ou (Bi,Pb)-Sr-Ca-Cu dans ladite matière première ne dépasse pas 5 % en masse de ladite matière première.

3. Procédé de fabrication d'un supraconducteur de type oxyde à base de bismuth selon la revendication 1, dans lequel la phase 2223 ayant la composition 2223 dans la composition de Bi-Sr-Ca-Cu ou (Bi,Pb)-Sr-Ca-Cu est formée successivement à partir du côté extérieur en direction du côté intérieur de ladite matière première chargée dans ladite gaine métallique dans ladite troisième étape.

4. Procédé de fabrication d'un supraconducteur de type oxyde à base de bismuth selon l'une quelconque des revendications précédentes, dans lequel la granulométrie moyenne du non-supraconducteur contenu dans ladite matière première ne dépasse pas 2 µm.

5. Fil supraconducteur contenant un supraconducteur de type oxyde à base de bismuth fabriqué par le procédé de fabrication d'un supraconducteur de type oxyde à base de bismuth selon la revendication 1.

6. Fil supraconducteur contenant un supraconducteur de type oxyde à base de bismuth selon la revendication 5 et fabriqué par le procédé de fabrication d'un supraconducteur de type oxyde à base de bismuth selon la revendication 4.

7. Fil supraconducteur selon la revendication 5 ou 6,
dans lequel l'angle de désordre d'orientation de la phase 2223 dudit supraconducteur de type oxyde à base de bismuth ne dépasse pas 8,5°, et
dans lequel l'angle de désordre d'orientation de la phase 2223 du supraconducteur de type oxyde à base de bismuth est défini comme étant la largeur à mi-hauteur d'une courbe d'oscillation du plan (0024) de la phase 2223 constituant le fil supraconducteur, mesurée par un procédé de diffraction des rayons X.
